# EUROPEAN PATENT APPLICATION

(11) **EP 2 428 805 A1**
(43) Date of publication of application: **14.03.2012**
(21) Application number: 10176447.0
(22) Date of filing: 13.09.2010
(51) Int. Cl.: G01R 31/28

(54) **Simulating an umbilical**

(71) Applicant: Vetco Gray Controls Limited, Bristol BS48 1BS (GB)
(72) Inventor: Puchianu, Silviu, Portishead, Bristol BS20 7AX (GB)
(74) Representative: Emerson, Peter James

(57) **Abstract**

A method of simulating an umbilical for use in a subsea fluid extraction well comprises using a programmed processing unit (9) to condition an electrical signal for producing a signal characteristic of a signal which has passed through such an umbilical.

## Description

### Field of the Invention

This invention relates to simulating an umbilical for use in a subsea fluid extraction well.

### Background of the Invention

In a subsea fluid extraction well, such a hydrocarbon extraction well, an umbilical, which can be up to several tens of kilometres in length, is used to transfer communications (for control and monitoring), electrical power, hydraulics and chemicals between an above-surface well control station and subsea control equipment, located on the subsea, which is used to control well operation. The type and complexity of an umbilical depends on the number of wells being controlled and the scope of supply of the subsea control equipment. Umbilicals are therefore designed specifically for each application. Due to the length and characteristics of an umbilical, it can cause detrimental effects to the signals and power being transmitted through it (such as loss of power, attenuation of signals and reflections which can cause overvoltages, etc). These aspects have to be taken into consideration in the design of the overall system.

When the subsea control equipment is brought together and assembled in its system configuration for testing prior to installation (such as at the factory or at a system test facility), there is a need to simulate the umbilical in order to provide the signal and power characteristics expected at its termination when testing, because it is impracticable to utilise the actual umbilical itself.

The main electrical aspects of subsea control equipment which need testing are the electrical aspects, which include the control and distribution of electrical power to the various equipments which are to be installed on the seabed and the communication between surface equipment and subsea equipment. The method of communication usually employed is known as communications-on-power (COP), where the communication signals are superimposed on the electrical power supply. Any electrical effects caused by the use of a long umbilical due to its particular electrical characteristics need to be simulated to ensure that the electrical power applied to the subsea control equipment in its test configuration is the same as that when installed and operational on the seabed and the method and characteristics of the communications (for example, COP) are the same.

At present, the method of testing adopted is to use a hardware representation of the umbilical in the form of specially designed electrical circuitry (an arrangement of passive components) which is connected between the main electrical supply and the subsea control equipment under test. A new umbilical simulator has to be designed and built for each test configuration, which is expensive and time consuming.

### Summary of the Invention

According to the present invention from one aspect, there is provided a method of simulating an umbilical for use in a subsea fluid extraction well, the method comprising using a programmed processing unit to condition an electrical signal for producing a signal characteristic of a signal which has passed through such an umbilical.

According to the present invention from another aspect, there is provided a method of testing control equipment for a subsea fluid extraction well, the method comprising simulating an umbilical using a programmed processing unit to condition an electrical signal for producing a signal characteristic of a signal which has passed through such an umbilical and supplying that signal to the control equipment.

In each such method, the electrical signal could be produced by a DC to AC converter, for example one which produces the electrical signal using pulse width modulation.

According to the present invention from a further aspect, there is provided apparatus for simulating an umbilical for use in a subsea fluid extraction well, the apparatus comprising a processing unit which is programmable or has been programmed for conditioning an electrical signal for producing a signal characteristic of a signal which has passed through such an umbilical.

Such apparatus could include a DC to AC converter for producing the electrical signal, for example one which is adapted for producing the electrical signal using pulse width modulation.

The present invention enables the design of a novel generic or universal programmable umbilical simulator which can be easily adapted for use in testing all subsea control equipment. This is achieved by including a programmable processing unit in a simulator so that only the software need be adapted to change the characteristics of the simulator as required.

### Brief Description of the Drawings

Fig. 1 is a schematic diagram of a typical subsea fluid extraction well control system; and
Fig. 2 is a schematic diagram of an embodiment of a simulator according to the invention.

### Description of an Embodiment of the Invention.

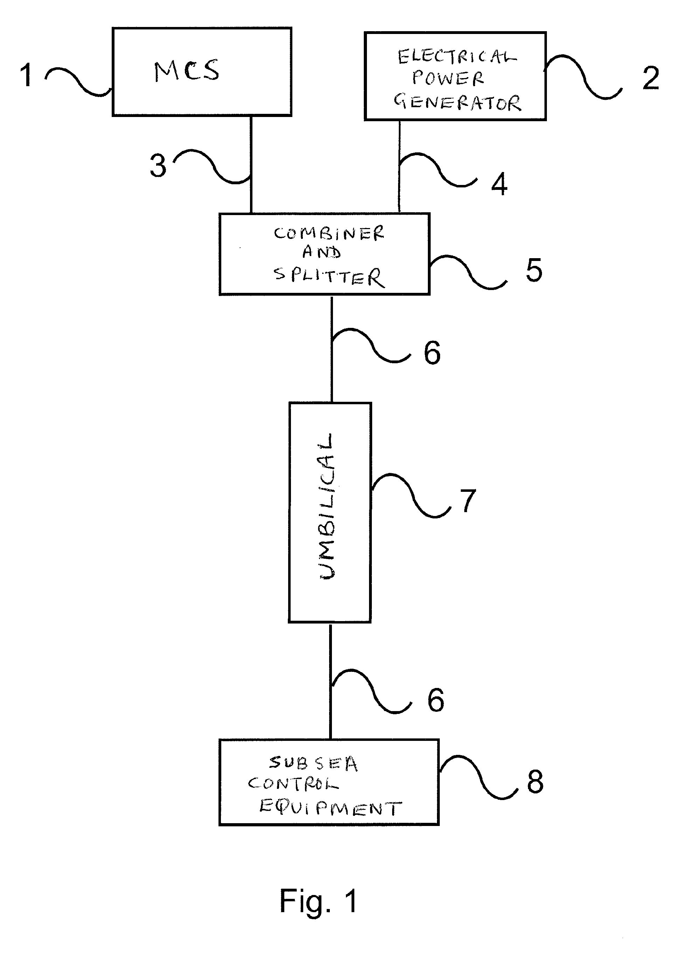

The configuration of a typical subsea fluid extraction well control system is shown in Figure 1. A master control station (MCS) 1, situated on a floating platform or rig, enables an operator to control the operation of an offshore well. An electrical power generator 2, which is usually co-located with the station 1, provides all the electrical power supply required by subsea control equipment 8 which is positioned on the subsea. The electrical power supply on a line 4 is passed to combiner and splitter equipment 5, where communication signals on line 3 from the master control station (i.e. control signals to the subsea control equipment) are combined with the electrical power supply. The combined electrical power and communication signals on a line 6 are then transmitted via an umbilical 7 to the subsea control equipment 8. Also, return sensor signals from the subsea control equipment on line 6 are split off by the splitter 5 and received by station 1 via line 3.

The umbilical 7 exhibits the characteristics of an electrical transmission line at both the operating frequency of the electrical power supply and that of the communications, such as signal attenuation, loss of power along its length and reflections due to load mismatch

The programmable umbilical simulator to be described is a single device that can be programmed to simulate the electrical behaviour of any umbilical, and can be used for any subsea system and is intended to replace the present variety of umbilical simulators with a single programmable one.

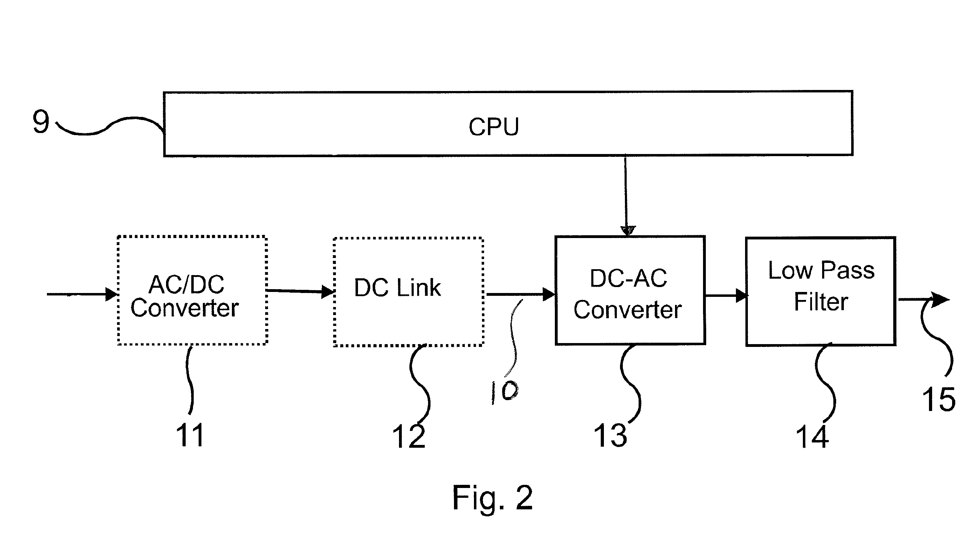

The configuration of the programmable umbilical simulator is shown in Fig. 2. The apparatus comprises a programmable central processing unit (CPU) 9 coupled to a DC to AC converter 13 which receives DC at an input 10. The converter 13 (in the form of a so-called H-bridge) converts the DC to AC using digitally controlled pulse width modulation (PWM) techniques to produce a power waveform which is acted on by CPU 9. More particularly, the CPU 9 has been programmed so that it distorts the waveform produced by converter 13 so that appropriate harmonic content is added to the power waveform so that the output from converter 13 is a simulation of the output of a particular umbilical. If it is desired that the simulation is one of a COP signal from the umbilical, the CPU 9 is programmed so that suitable information is also added to or imprinted on the distorted power waveform to achieve that.

The above simulator would be used at a test facility for testing subsea control equipment, the output from converter 13 being supplied to the equipment to be tested via an output 15, if necessary via an optional low pass filter 14.

If only AC electrical power is available at the test facility, the simulator will include an AC/DC converter 11 and a DC link 12 to provide the DC input power required by the DC-AC converter 13.

### Advantages of using the Invention

Some advantages of a programmable umbilical simulator according to the invention are set out below.

More comprehensive testing of systems can be carried out as a programmable simulator enables a wider range of umbilical characteristics and different system possibilities to be simulated for a single test configuration.

Having to design, develop, and build an umbilical simulator for each subsea control equipment to be tested is time consuming, uses manpower and is expensive. The use of a generic simulator will significantly reduce these costs. This is because the changes required are limited to the software content, the hardware design requiring no modifications.

The programmable umbilical simulator is a product in its own right as it can be supplied as a test tool forming part of the test equipment supplied to a customer for testing and maintenance or as a separate product.

## Claims

1. A method of simulating an umbilical for use in a subsea fluid extraction well, the method comprising using a programmed processing unit to condition an electrical signal for producing a signal characteristic of a signal which has passed through such an umbilical.

2. A method according to claim 1, wherein the electrical signal has been produced by a DC to AC converter.

3. A method according to claim 2, wherein the converter produces the electrical signal using pulse width modulation.

4. A method of testing control equipment for a subsea fluid extraction well, the method comprising simulating an umbilical using a programmed processing unit to condition an electrical signal for producing a signal characteristic of a signal which has passed through such an umbilical and supplying that signal to the control equipment.

5. A method according to claim 4, wherein the electrical signal has been produced by a DC to AC converter.

6. A method according to claim 5, wherein the converter produces the electrical signal using pulse width modulation.

7. Apparatus for simulating an umbilical for use in a subsea fluid extraction well, the apparatus comprising a processing unit which is programmable or has been programmed for conditioning an electrical signal for producing a signal characteristic of a signal which has passed through such an umbilical.

8. Apparatus according to claim 7, including a DC to AC converter for producing the electrical signal.

9. Apparatus according to claim 8, wherein the converter is adapted for producing the electrical signal using pulse width modulation.
